# EUROPEAN PATENT APPLICATION

(11) **EP 0 689 240 A1**
(43) Date of publication of application: **27.12.1995**
(21) Application number: 94109767.7
(22) Date of filing: 24.06.1994
(51) Int. Cl.: H01L 21/60

(54) **Bonded structure and methods for forming this structure**

(71) Applicant: INDUSTRIAL TECHNOLOGY RESEARCH INSTITUTE, Chutung, Hsinchu 31015 (TW)
(72) Inventor: Chang, Shyh-Ming, Hsinchu (TW); Jou, Jwo-Huei, Hsinchu (TW); Lee, Yu-Chi, Sanchung, Taipei Hsien (TW); Hu, Dyi-Chung, Shuang-Shi Tsun, Hsinchu (TW); Yu, Hsiu-Mei, Chutung, Hsinchu Hsien (TW); Yang, Li-Hui, Chutung, Hsinchu Hsien (TW); Chu, Chih-Chiang, Taipei (TW)
(74) Representative: Schmidt-Bogatzky, Jürgen, Dr. Ing.

(57) **Abstract**

A bonded structure comprising the physical and electrical connections between an integrated circuit element and substrate using a composite bump comprised of a single polymer body of low Young's Modulus and a conductive metal coating. When the bonded structure is formed the composite bump is deformed and the low Young's Modulus of the polymer body allows a very reliable bonded structure with very low bonding force. Due to the low Young's Modulus there is little tendency to separate the connections after the bonded structure is formed. The bond can be formed using thermocompression bonding, ultrasonic bonding, application of heat or application of light. The bond can also be formed using a non conductive adhesive between the integrated circuit element and the substrate. The bond can also be formed with a conductive adhesive coating on the composite bump. The polymer body may be covered by a conductive metal coating formed at the input/output pads of an integrated circuit element or substrate. The composite bump is formed using material deposition, lithography, and etching techniques. A layer of soldering metal can be formed on the composite bumps if this is desired for subsepuent processing.

It is possible to use a conductive barrier metal coating covering the polymer body and a soldering metal coating covering the conductive barrier metal coating. When the bonded structure is formed the composite bump is deformed and the low Young's Modulus of the polymer body allows a very reliable bonded structure with very low bonding force. Due to the low Young's Modulus there is little stress tending to break the solder joint after the bonded structure is formed. The bond is formed using a soldering process so that the soldering metal forms a conductive adhesive between the composite bumps and either the substrate input/output pads or the integrated circuit element input/output pads.

## Description

### BACKGROUND OF THE INVENTION

The invention relates to bonded structures and methods of forming this structures for the joining of integrated circuit elements to the next level of integration, or that level of integration to the following level, and more particularly to the formation of the bonded structures which comprises the physical and electrical connection between the integrated circuit element and the next level of integration.

In the manufacture of highly dense integrated circuits the formation of an inexpensive and highly reliable mechanical bond and electrical interconnection between the integrated circuit element and substrate has long been recognized to be of key importance. Some time ago a solution to this need was patented by L. F. Miller et al in US Pat. No. 3,401,126. This method worked well for many years but increasing levels of integration and circuit density have made the need for interconnections on an increasingly fine pitch of key importance.

A method for achieving increased interconnection density was patented by K. Hatada in US Pat. No. 4,749,120. This method employs a metal bump as the 4,749,120. This method employs a metal bump as the electrical interconnection between the integrated circuit chip and the substrate while holding the integrated circuit chip in place with a resin coating on the substrate acting as an adhesive between chip and substrate. This method has the disadvantage of a relatively high Young's Modulus for metals, especially for gold when compared to that of the resin. As a result of the high Young's Modulus a very large bonding force is required between the integrated circuit chip and the substrate during the micro-bump bonding process while the resin is undergoing its curing cycle. After the bonding process the gold micro-bump will tend to return to its original shape and the recoil forces will disengage some of the micro-bumps from the electrodes on the substrate. Another method patented by Y. Tagusa et al in US Pat. No. 4,963,002 employs nickel plated plastic beads or silver particles to achieve the electrical connection, but the former suffers from small contact surface area and the latter suffers the disadvantage of a relatively high Young's Modulus for silver.

US Pat. No. 4,916,523 issued to Sokolovsky et al shows a unidirectional conductive adhesive to bond the integrated circuit chip to the substrate. US Pat. No. 5,134,460 issued to Brady et al shows conductive metal bumps coated with a gold layer.

Furtheron flip chip bonding has been done using several types of bumps. One type simply uses a lead-tin solder or indium alloy solder as the bump which bonds the integrated circuit chip to a substrate. This type of bonding can result in shorting between bumps during solder reflow. Another type of bump uses a copper ball within the lead-tin or indium alloy solder. The copper ball does not melt during solder reflow so there will not be a shorting. However since the copper ball is rigid there can be problems with cracking of joints. Another type of structure is a stack of solder bumps. This type of structure is not easily shorted during reflow and the cracking problem is not present. However, it is difficult to make fine pitch solder reflow joints with this method because of stack misalignment problems.

### SUMMARY OF THE INVENTION

It is the principal object of the invention to provide a bonded structure comprising the electrical and physical connections between integrated circuit elements and the corresponding substrate wherein very dense wiring patterns can be accommodated economically and the resulting connections are extremely reliable.

This object is achieved with a bonded structure comprising the integrated circuit element input/output pads, composite bumps comprised of a single polymer body with a Young's Modulus which is low compared to metals and a conductive metal coating covering the polymer body, and the substrate input/output pads. The conductive metal coating covering the polymer body must be chosen to provide good adhesion to the polymer body and may include an adhesive layer and a barrier layer in addition to a conductor layer. The low Young's Modulus of the polymer, about 0.4 X 10⁶ to 0.5 X 10⁶ psi, allows the bond to be made with very low bonding force and greatly reduces or eliminates the force tending to separate the connections after the bonding force is removed. This results in extremely reliable physical and electrical connections between the integrated circuit element and substrate.

It is the second principal object of this invention to provide a composite bump which can be formed on an integrated circuit element, on the substrate to which the integrated circuit element is connected, or on both the integrated circuit element and the substrate. The composite bumps are comprised of a single polymer body with a Young's Modulus which is low compared to metals and a conductive metal coating covering the polymer body. The conductive metal coating covering the polymer body must be chosen to provide good ahesion to the polymer body and may include an adhesive layer and a barrier layer in addition to a conductor layer. The composite bump forms part of the physical and electrical bond between the integrated circuit element and the substrate. The low Young's Modulus of the polymer, between about 0.4 X 10⁶ and 0.5 X 10⁶ psi, allows the bond to be made with very low bonding force, greatly reduces or eliminates the force tending of separate the connections after bonding, and results in extremely reliable physical and electrical connections between the integrated circuit element and substrate.

It is a third object of this invention to provide a solder reflow bonded structure which is not easily shorted during solder reflow, does not easily crack after solder reflow and which easily accommodates a fine pitch solder reflow. This objective is accomplished with a composite bump included in a solder joint. The composite bump includes a single polymer body with a low Young's Modulus relative to that of metals and a conductive metal coating covering the polymer body. The bonded structure includes an integrated circuit element with input/output pads, a substrate with input/output pads, composite bumps which connect the integrated circuit element input/output pads and the substrate input/output pads, and soldering metal which forms the solder joint. The bonded structure is not easily shorted during a solder reflow bonding process, can accommodate a very fine pitch solder reflow easily, and does not easily crack after solder reflow is complete. The bonded structure of this invention forms the electrical and physical connections between integrated circuit elements and the corresponding substrate wherein very dense wiring patterns can be accommodated economically and the resulting connections are extremely reliable.

In accordance to the first object of the invention it is a further object of the invention to provide a method of forming a bonded structure comprising the electrical and physical connections between integrated circuit elements and the corresponding substrate wherein very dense wiring patterns can be accommodated economically and the resulting connections are extremely reliable.

This object is achieved by forming a bonded structure comprising the integrated circuit element input/output pads, composite bumps comprised of a single polymer body with a Young's Modulus which is low compared to metals and a conductive metal coating covering the polymer body, and the substrate input/output pads. The conductive metal coating covering the polymer body must be chosen to provide good adhesion to the polymer body and may include an adhesive layer and a barrier layer in addition to a conductor layer. The composite bump will be deformed during the bonding process and the low Young's Modulus of the polymer, about 0.4 X 10⁶ to 0.5 X 10⁶ psi, allows the bond to be made with very low bonding force and greatly reduces or eliminates the force tending to separate the connections after the bonding force is removed. The polymer body and the conductive metal coating must be chosen to be compatible with the temperatures used during the bonding process.

In accordance to the second object of the invention to this it is a further object to provide methods of fabrication of the composite bump on either an integrated circuit element or a substrate to which an integrated circuit element can be connected. This objective is achieved by depositing a layer of polymer on the surface of an integrated circuit element or substrate. Using photolithographic techniques the polymer is removed everywhere except at the location of the integrated circuit element or substrate input/output pads. Metal is then deposited over the surface of the integrated circuit element or substrate. Using photolithographic techniques the metal is removed everywhere except at the location of the integrated circuit element or substrate input/output pads and the composite bumps are formed. The resulting composite bumps have a single polymer body with a low Young's Modulus relative to metals and a conductive metal coating covering the polymer body. In some instances a metal layer can be formed on the input/output pads and under the polymer body. This metal layer reduces the sheet resistance of the input/output pads. The polymer body must be chosen to withstand the temperatures of subsequent processing such as bonding. The polymer body must also be chosen so that it can be etched during fabrication of the composite bump. Polyamic acid polyimide fulfills these requirements. The conductive metal coating covering the polymer body must be chosen to provide good adhesion to the polymer body and may include an adhesive layer and a barrier layer in addition to a conductor layer.

In accordance to the third object of the invention it is a further object to provide a method of forming a bonded structure which includes solder joints and composite bumps. This objective is achieved by forming composite bumps on the input/output pads of an integrated circuit element or substrate, forming a layer of soldering metal on the composite bumps, bringing the integrated circuit element and substrate together and heating the solder to solder reflow temperature. Alternatively the objective can be achieved by forming composite bumps on the input/output pads of an integrated circuit element or substrate, forming a layer of soldering metal on the input/output pads which do not have the composite bumps, bringing the integrated circuit element and substrate together and heating the solder to reflow temperature.

### BRIEF DESCRIPTION OF DRAWINGS

Fig. 1 is a cross sectional representation of the composite bump formed on the integrated circuit element showing the polymer interior and conductive metal coating of the composite bump.

Fig. 2 is a cross sectional representation of the bonded structure with the composite bumps formed on the integrated circuit element prior to bonding.

Fig. 3 is a cross sectional representation of the composite bump formed on the substrate showing the polymer interior and conductive metal coating of the composite bump.

Fig. 4 is a cross sectional representation of the bonded structure with the composite bumps formed on the substrate prior to bonding.

Fig. 5 is a cross sectional representation of the composite bump formed on both the integrated circuit element and the substrate showing the polymer interior and conductive metal coating of the composite bumps.

Fig. 6 is a cross sectional representation of the bonded structure with the composite bumps are formed on both the integrated circuit element and the substrate prior to bonding.

Fig. 7 is a cross sectional representation of the bonded structure wherein a conducting adhesive bonds the conducting metal coating of the composite bump to the substrate input/output pad.

Fig. 8 is a cross sectional representation of the bonded structure wherein a conducting adhesive bonds the conducting metal coating of the composite bump to the integrated circuit element input/output pat.

Fig. 9 is a cross sectional representation of the bonded structure wherein a conducting adhesive bonds the conducting metal coating of the integrated circuit element composite bump to the substrate composite bump.

Fig. 10 is a cross sectional representation of the bonded structure wherein a non conducting adhesive bonds the integrated circuit element to the substrate.

Fig. 11A shows a cross sectional view of a composite bump formed on an integrated circuit element or substrate.

Fig. 11B shows a cross sectional view of a composite bump formed on an integrated circuit element or substrate with a solder coating on the composite bump.

Fig. 12 shows a cross sectional view of a composite bump formed in a hemispherical shape on an integrated circuit element or substrate.

Fig. 13 shows a cross sectional view of a composite bump formed with a rough shape on an integrated circuit element or substrate.

Fig. 14 shows a cross sectional view of composite bumps formed so that there are multiple bumps within the input/output pattern of an integrated circuit element or substrate.

Fig. 15 shows a cross sectional view of composite bumps formed so that there are multiple bumps within and extending beyond the input/output pattern of an integrated circuit element or substrate.

Fig. 16 shows a cross sectional view of composite bumps formed so that there are multiple bumps forming a ring around the input/output pattern of an integrated circuit element or substrate.

Figs. 17A through 17I shows cross sectional representations of the method for forming composite bumps using photoresist for pattering the polymer and metal layers.

Figs. 18A through 18J shows cross sectional representations of the method for forming composite bumps with a base metal layer under the composite and on top of the input/output pad using photoresist for patterning the polymer and metal layers.

Figs. 19A through 19G shows cross sectional representations of the method for forming composite bumps using photosensitive polymer to pattern the polymer layer and photoresist to pattern the metal layer.

Figs. 20A through 20H shows cross sectional representations of the method for forming composite bumps with a base metal layer under the composite bump and on top of the input/output pad using photosensitive polymer to pattern the polymer layer and photoresist to pattern the metal layer.

Figs. 21A through 21E shows cross sectional representations of the method for forming composite bumps using a lift off process.

Figs. 22A through 22C shows cross sectional representations of the method for forming a solder layer on the composite bumps.

Fig. 23 is a cross sectional representation of composite bumps with a solder layer formed on the integrated circuit element input/output pads before soldering.

Fig. 24 is a cross sectional representation of structure after soldering where the composite bumps and the solder layer were formed on the integrated circuit element input/output pads prior to soldering.

Fig. 25 is a cross sectional representation of composite bumps with a solder layer formed on the substrate input/output pads before soldering.

Fig. 26 is a cross sectional representation of structure after soldering where the composite bumps and the solder layer were formed on the substrate input/output pads prior to soldering.

Fig. 27 is a cross sectional representation of composite bumps formed on the integrated circuit element input/output pads and a solder layer formed on the substrate input/output pads prior to soldering.

Fig. 28 is a cross sectional representation of the structure after soldering where composite bumps were formed on the integrated circuit element input/output pads and the solder was formed on the substrate input/output pads prior to soldering.

Fig. 29 is a cross sectional representation of a composite bumps formed on the substrate input/output pads and a solder layer formed on the integrated circuit element input/output pads prior to soldering.

Fig. 30 is a cross sectional representation of the structure after soldering where composite bumps were formed on the substrate input/output pads and the solder was formed on the integrated circuit element input/output pads prior to soldering.

### DESCRIPTION OF THE PREFERRED EMBODIMENTS

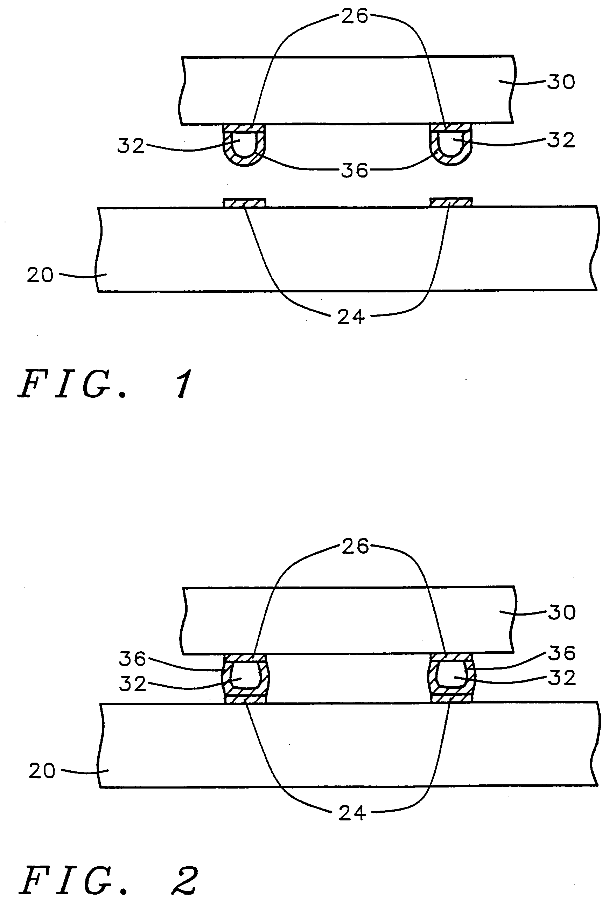

Refer now more particularly to Figs. 1 and 2, there is shown an embodiment for the bonded structure of the current invention. Composite bumps are formed on the integrated circuit element 30 input/output pads 26. The input/output pads 26 are formed of a metal such as aluminium with a diameter of about 90 microns. Each composite bump comprises a single polymer body 32 and a conductive metal coating 36 covering the polymer body. The polymer body must withstand temperatures encountered during bonding and can be polyamic acid polyimide such as PROBIMIDE 7010 or PROBIMIDE 514 produced by OCG Microelectronic Materials, Inc., Tempe, AZ. The polymer body has a thickness of between about 5 and 25 microns. Input/output pads 24 are formed on the substrate 20 using a metal such as aluminum.

The conductive metal coating 36 must adhere to the polymer body and can be a metal such as aluminum or nickel; or a composite such as nickel/gold, chrome/gold, chrome/silver, or titanium/platinum. The conductive metal coating can be a composite which includes an adhesion layer/a barrier layer/a conductor layer such as chrome/copper/gold, chrome/nickel/gold, chrome/silver/gold, titanium/platinum/gold, titanium/palladium/gold, or titanium/tungsten/silver.

When the bonded structure is formed the composite bumps will contact the substrate input/output pads and will be deformed as shown in Fig. 2 so that each composite bump will contact a substrate input/output pad. Due to the low Young's Modulus of the polymer body a very small force, about one tenth that required by the traditional gold bump, is required for this deformation and there is little tendency to separate the bonded structure after it has been formed.

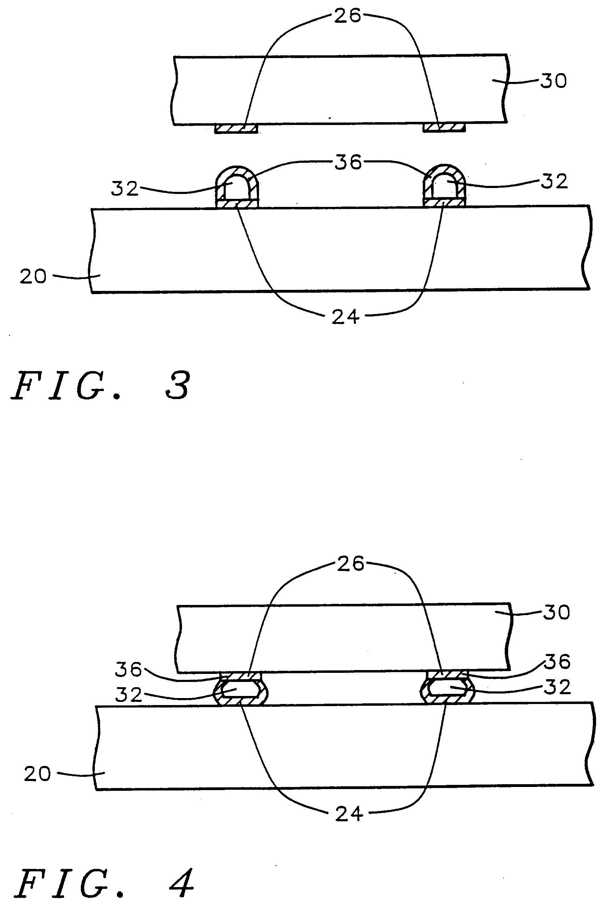

Refer now to Figs. 3 and 4, there is shown another embodiment of the bonded structure. In this embodiment the composite bumps are formed on the substrate input/output pads 24. The composite bump and the structure after the bond is formed is as described above.

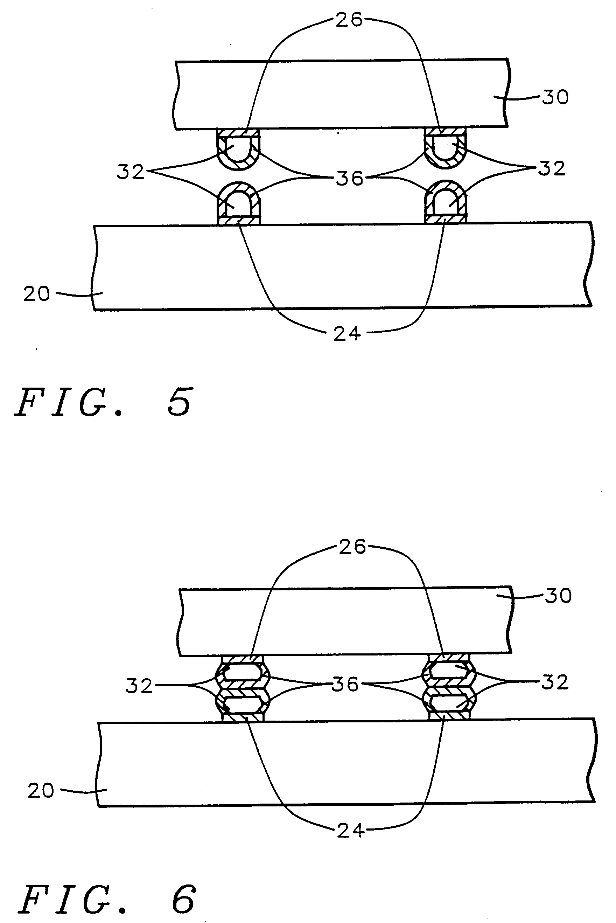

Another embodiment is shown in Figs. 5 and 6. In this embodiment the composite bumps are formed on both the integrated circuit element input/output pads 26 and the substrate input/output pads 24. When the bonded structure is formed the substrate composite bumps are brought together with the integrated circuit element composite bumps. The composite bumps are deformed and due to the low Young's Modulus of the polymer body a very small force is required for this deformation and there is little tendency to separate the bonded structure after it has been formed.

The integrated circuit element 30 and the substrate 20 are brought together so that the conductive metal coating 36 on each composite bump contacts a substrate input/output pad 24 as shown in Fig. 4 or a corresponding composite bump as shown in Fig. 6. The bond is then formed using a bonding process such as thermocompression bonding, ultrasonic bonding, tape automated bonding, application of heat energy, or application of light energy.

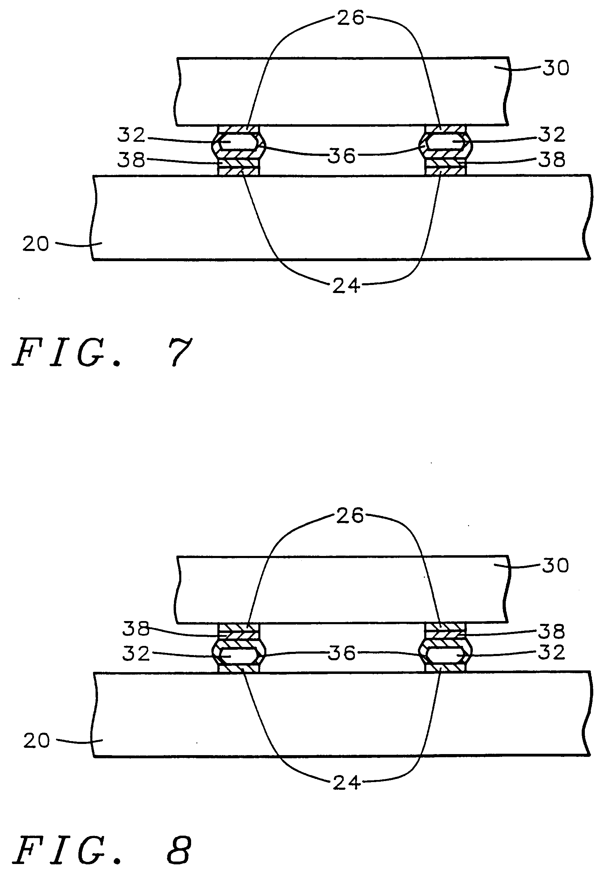

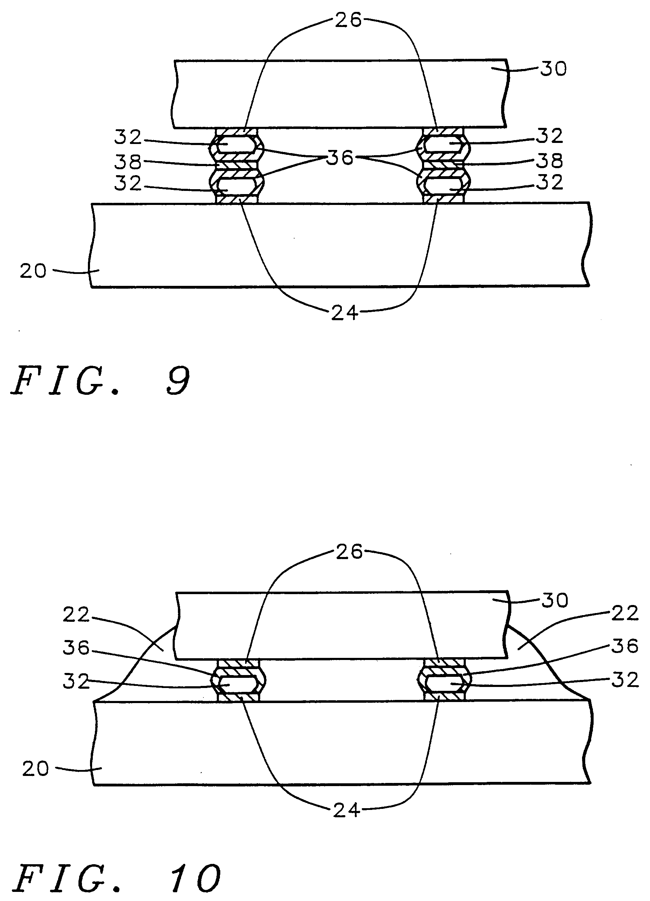

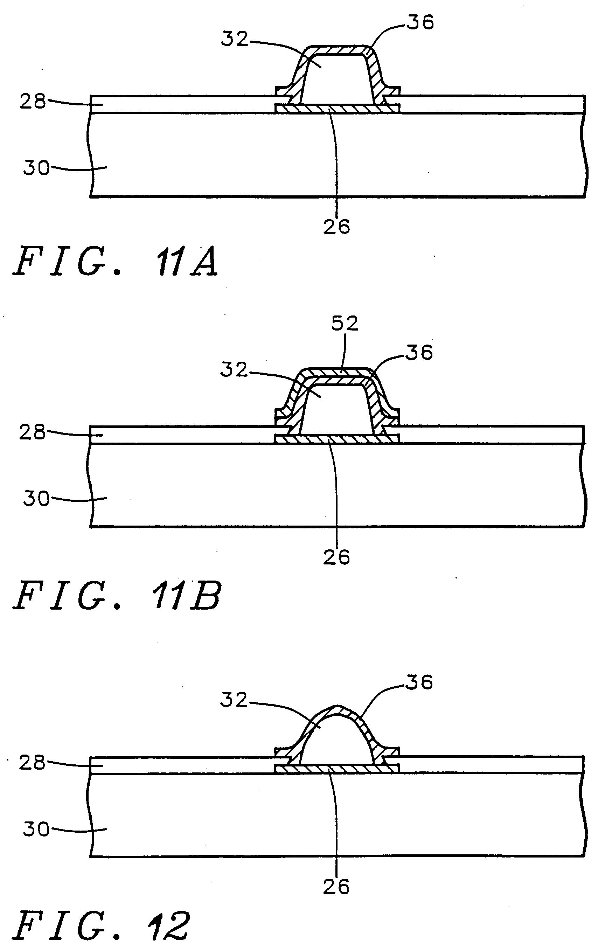

As shown in Figs. 7, 8 and 9 the bonding may also be accomplished using a conductive adhesive 38 between the conductive metal coating 36 of each composite bump and the corresponding substrate pad 24 shown in Fig. 7, the corresponding integrated circuit element input/output pad 26 shown in Fig. 8, or the corresponding composite bump shown in Fig. 9. As shown in Fig. 10, the bonding may also be accomplished using a nonconductive adhesive 22 between the integrated circuit element 30 and substrate 20. The conductive and nonconductive adhesives may require the application of heat energy or light energy. During the bonding process the polymer body in each composite bump is deformed as electrical connection is formed. This deformation is important in forming a good electrical contact, Due to the low Young's Modulus of the polymer body this deformation requires a very small bonding force and produces little or no tendency to separate the connection after is has been made.

Fig. 11A shows an embodiment of the composite bump formed on either an integrated circuit element or on a substrate. A passivation layer 28 and an aluminum input/output pad 26 of about 90 microns diameter is formed on an integrated circuit element or substrate 30. A polymer body 32 with a thickness of between about 5 microns and 25 microns is formed on the input/output pad 26. The polymer body can be polyamic acid polyimide such as PROBIMIDE 7010 or PROBIMIDE 514 produced by OCG Microelectronic Materials, Inc., Tempe, AZ.

A conductive metal coating 36 is formed over the polymer body and must adhere to the polymer body. The coating can be a metal such as aluminum or nickel; or a composite such as nickel/gold, chrome/gold, chrome/silver, or titanium/platinium. The conductive metal coating 36 can be a composite which includes an adhesion layer/a barrier layer/ a conductor layer such as chrome/copper/gold, chrome/nickel/ gold, chrome/silver/gold, titanium/platinium/gold, titanium/palladium/gold, or titanium/tungsten/silver. A solder coating, such as PbSn, InGa, or InSn may be formed over the conductive metal coating, shown in Fig. 11B, if this is desired for a soldering process. In this case the preferred conductive metal coatings are chrome/copper/gold, chrome/nickel/gold, chrome/silver/gold, titanium/platinum/gold, or titanium/ palladium/gold.

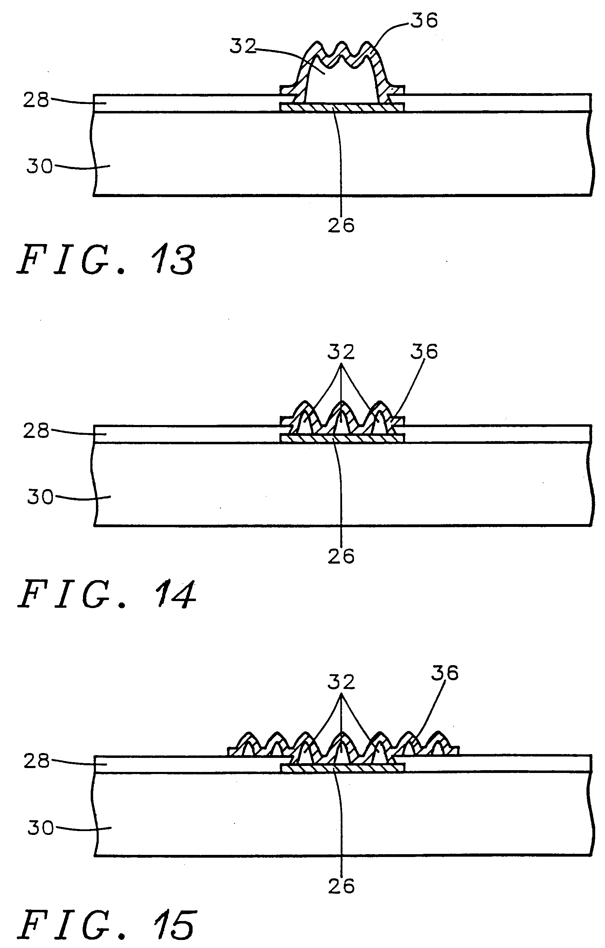

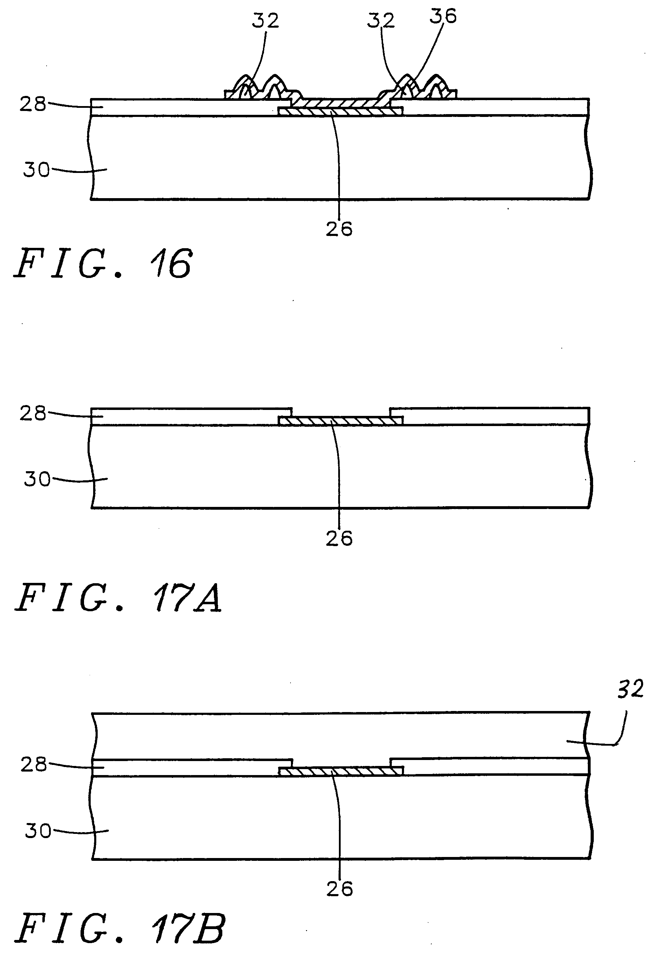

Additional embodiments of the composite bump are shown in Fig. 12 through Fig. 16. Fig. 12 shows a composite bump formed in a hemispherical shape. Fig. 13 shows a composite bump formed with a rough surface on the bump. Fig. 14 shows multiple composite bumps formed inside the input/output pattern 26 of the integrated circuit element or substrate 30. Fig. 15 shows multiple composite bumps formed both inside and in a ring surrounding the input/output pattern 26 of the integrated circuit element or substrate 30. Fig. 16 shows multiple composite bumps formed in a ring surrounding the input/output pattern 26 of the integrated circuit element or substrate 30.

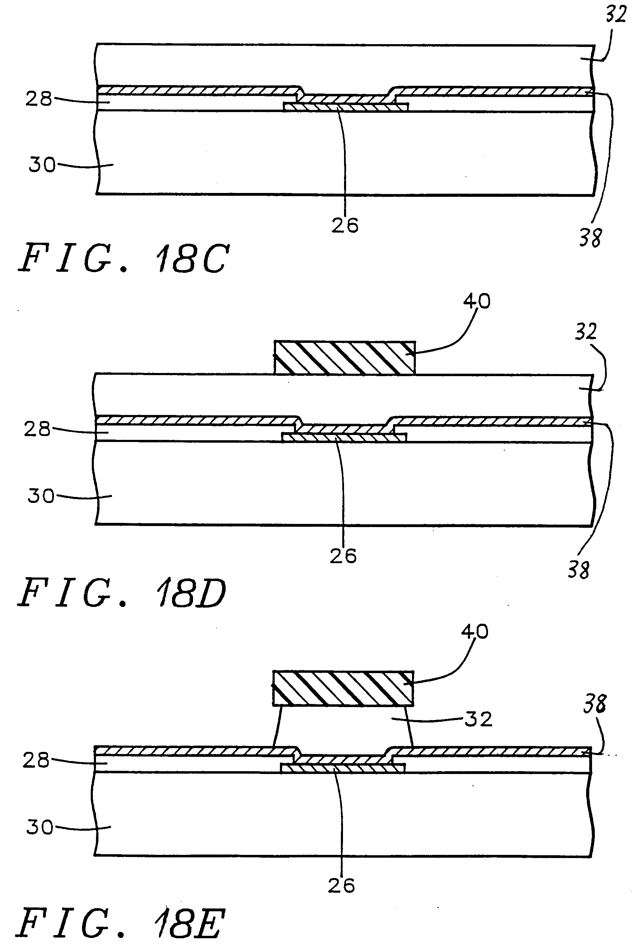

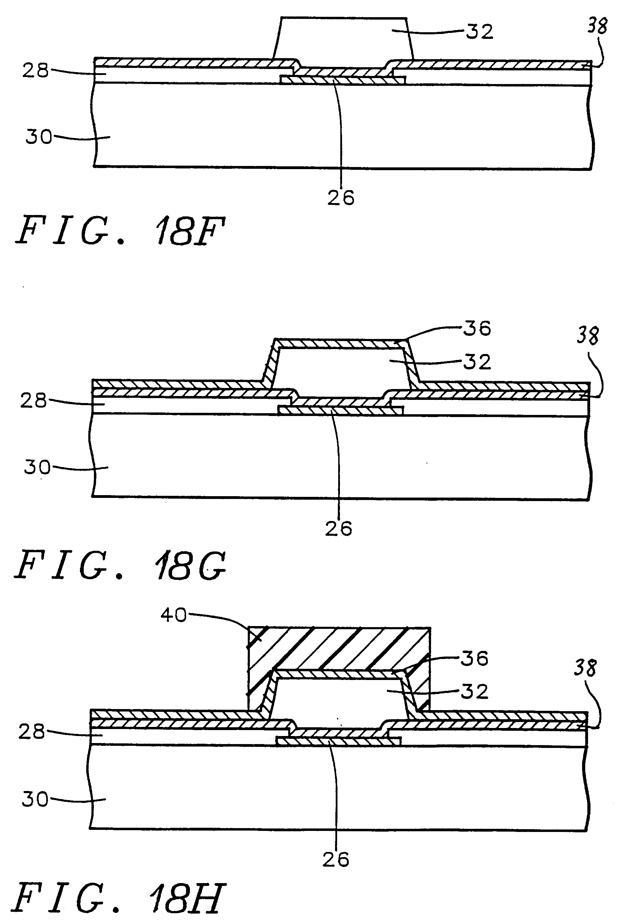

The above embodiments may also have a base metal layer of aluminum 38 formed under the polymer body 32 and on top of the input/output pad 26 as shown in Fig. 18J. This base metal layer extends over the edges of the passivation layer 28.

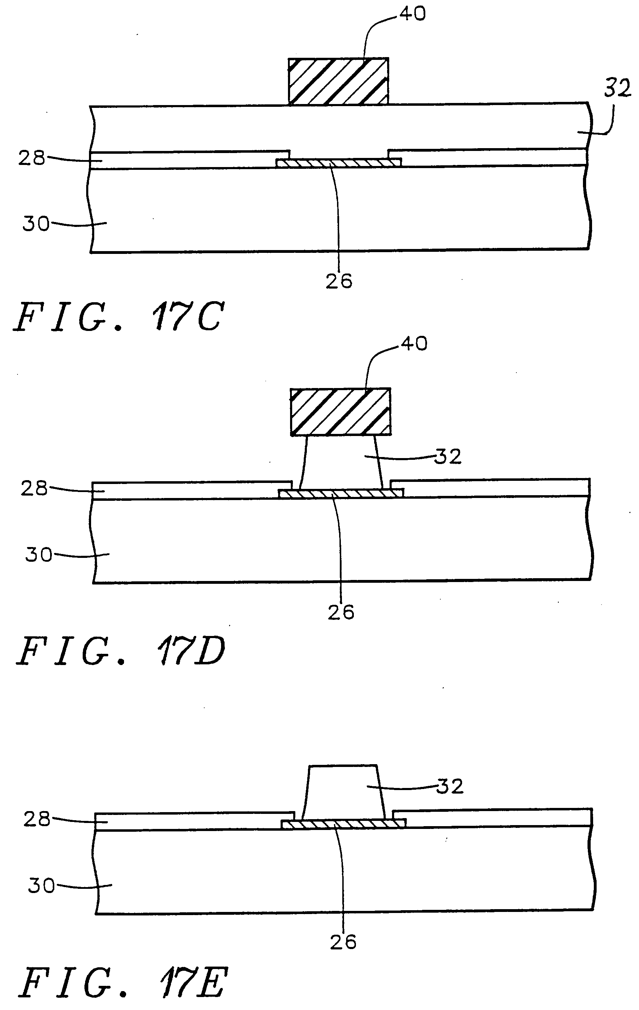

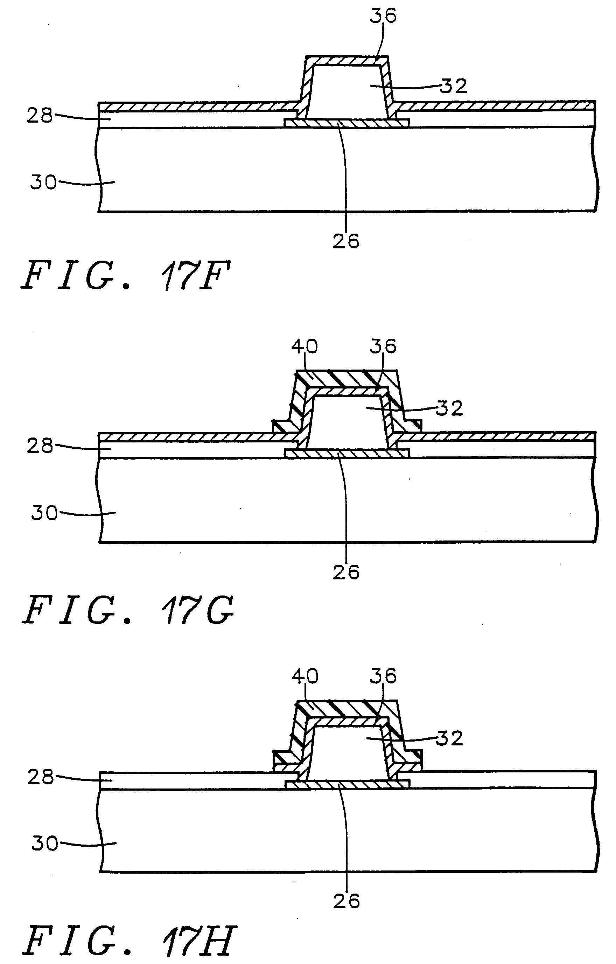

Refer now more particularly to Figs. 17A through 17I. There is shown an embodiment of a method for forming the composite bump of the current invention. First the integrated circuit element or substrate 30 with a passivation layer 28 and aluminum input/output pads 26 with a diameter of about 90 microns is etched and cleaned, as shown in Fig. 17A. Next, as shown in Fig. 17B, a layer of non photosensitive polymer 32 such as a polyamic acid polyimide like PROBIMIDE 514 produced by OCG Microelectronic Materials, Inc., Tempe, AZ. with a thickness of between about 5 and 25 microns is formed on the surface of the integrated circuit element or substrate 30. Next, as shown in Fig. 17C, a photoresist pattern 40 is formed on the polyamic acid polyimide. As shown in Fig. 17D, the polyamic acid polyimide is then etched to the photoresist pattern using MF-319 at room temperature for between about 1 and 3 minutes. Patterning of polyimide films is described in Chapter 8 of POLYIMIDES edited by Wilson, Stenzenberger, and Hergenrother published by Blackie & Son Ltd. in 1990. The photoresist is then stripped, Fig. 17E. As shown in Fig. 17F a conductive metal layer 36 such as a composite of chrome/gold with chrome about 500 Angstroms thick and gold about 2000 Angstroms thick is deposited on the integrated circuit element or substrate 30. The coating 36 can also be a metal such as aluminum or nickel; or a composite such as nickel/gold, chrome/silver, or titanium/platinum. The conductive metal coating 36 can also be a composite which includes an adhesion layer/ a barrier layer/ a conductor layer such as chrome/copper/gold, chrome/nickel/gold, chrome/silver/gold, titanium/platinum/gold, titanium/palladium/gold, or titanium/tungsten/silver.

A patterned layer of photoresist 40, Fig. 17G, is then formed on the conductive metal layer 36 and the conductive metal layer is etched to the pattern, of the photoresist 40, Fig. 17H. The photoresist is then stripped, Fig. 17I, and the composite bump is formed. For the chrome/gold conductive metal layer etching can be accomplished using 1g Ce (SO₄) ₂*2(NH₄)₂SO₄*2H₂0 + 5ml HNO₃ + 25ml H₂O at 28°C to etch chrome at about 85 Angstroms/minute and 4g KI + 1g I₂ + 40ml H₂O at room temperature to etch gold at between about 0.5 and 1.0 microns/minute.

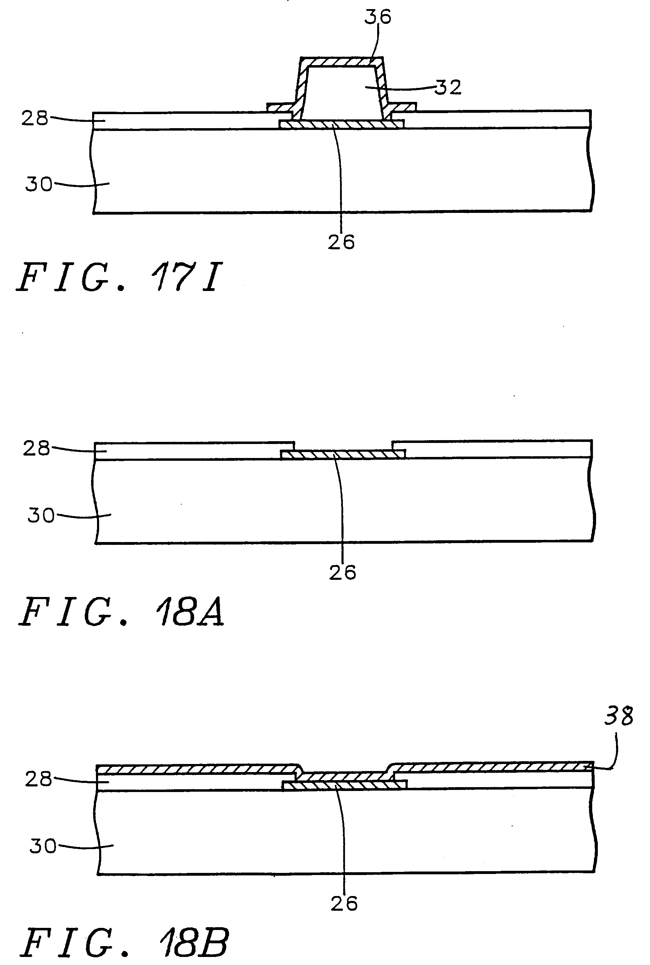

Another embodiment method is shown in Figs. 18A through 18J. The integrated circuit element or substrate 30 with a passivation layer 28 and aluminum imput/output pads 26 with a diameter of about 90 microns is etched and cleaned, as shown in Fig. 18A. Next, as shown in Fig. 18B, a layer of metal 38 such as aluminum is deposited on the integrated circuit element or substrate 30. The method then proceeds as described in the immediately preceding embodiment beginning with the formation of the layer of polyamic acid polyimide 32 and continuing until the conductive metal coating 36 is etched, Figs. 18C to 18I. The aluminum 38 is then etched using H₃PO₄: CH₃COOH:HNO₃:H₂O (4:4:1:1) at room temperature at about 350 Angstroms/minute. As shown in Fig. 18J the photoresist is then stripped and the composite bump is formed.

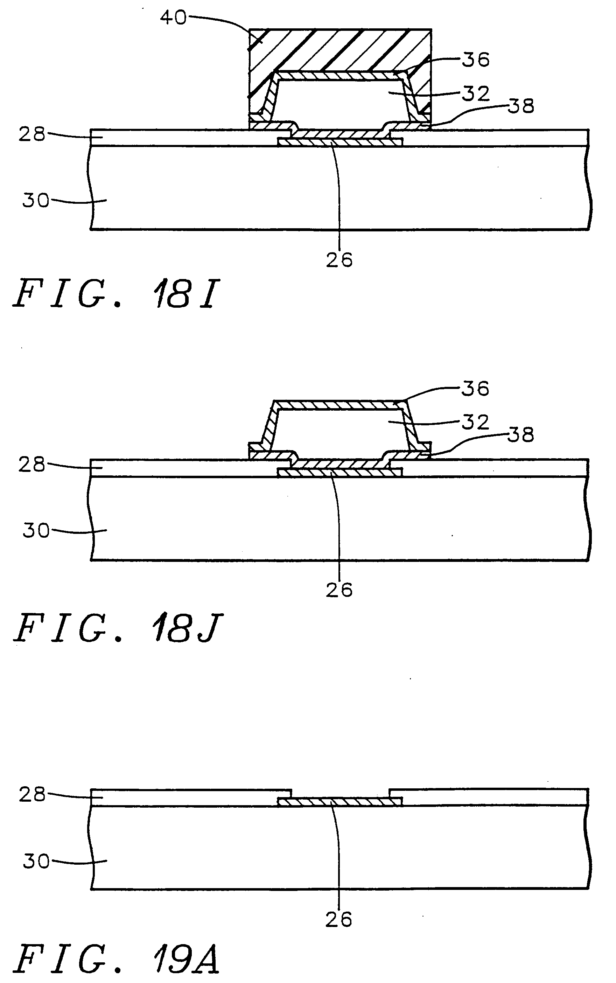

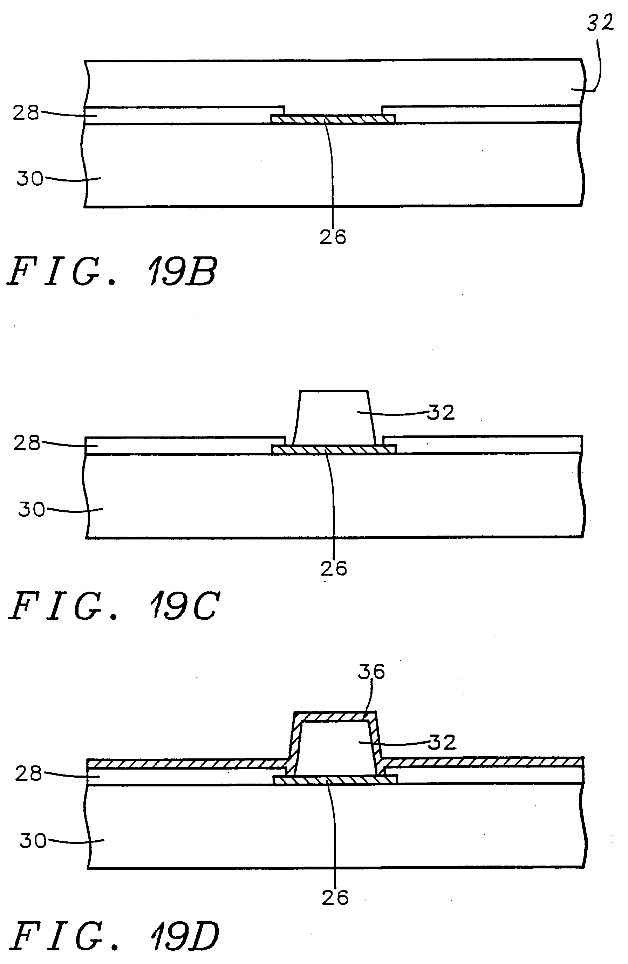

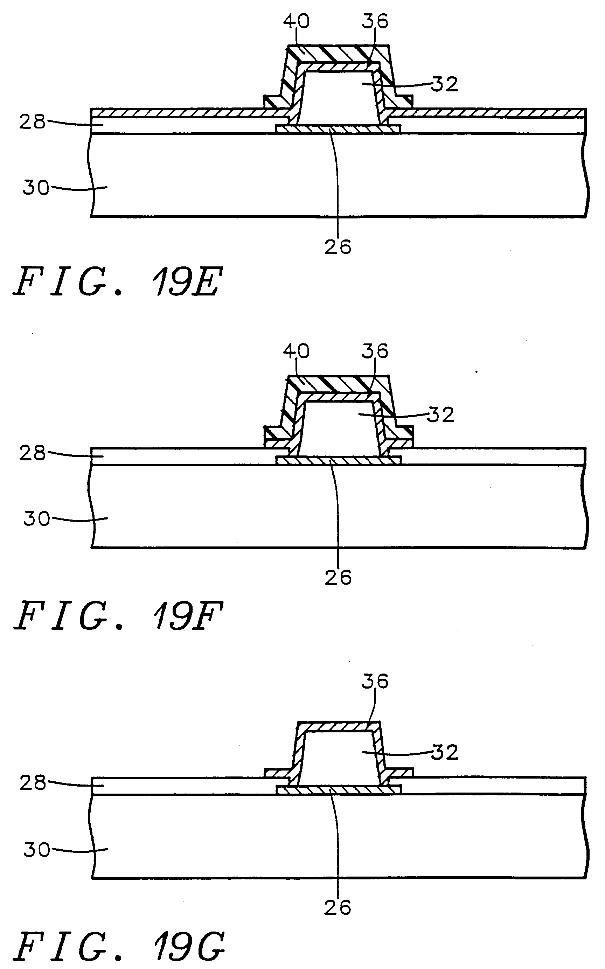

Another embodiment method is shown in Figs. 19A through 19G. After the integrated circuit element or substrate 30 with input/output pads of about 90 microns diameter is etched and cleaned, Fig. 19A, a layer of photosensitive polymer 32 such as photosensitive polyamic acid polyimide, like PROBIMIDE 7020 produced by OCG Microelectronic Materials, Inc., Tempe, AZ. with a thickness of between about 5 and 25 microns is formed on the surface integrated circuit element or substrate 30, Fig. 19B. The photosensitive polymer 32 is exposed and developed leaving polymer 32 only over the input/output pads, Fig. 19C. Patterning of polyimide films is described in Chapter 8 of POLYIMIDES edited by Wilson, Stenzenberger, and Hergenrother published by Blackie & Son Ltd. in 1990. Next a conductive metal layer 26 such as a composite of chrome/gold is deposited on the integrated circuit element or substrate 30 as shown in Fig. 19D and the process proceeds as described in the previous embodiment, Figs. 19E, 19F, and 19G.

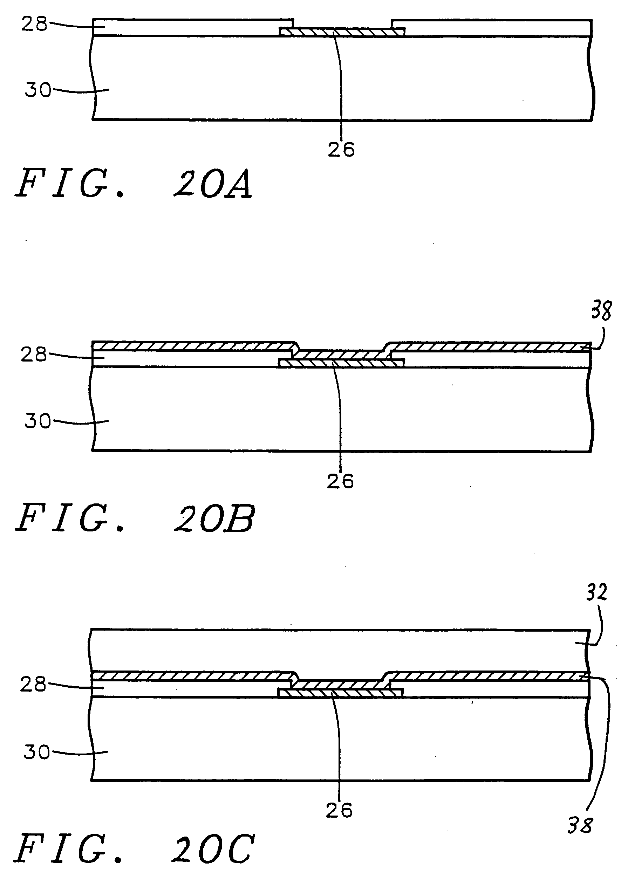

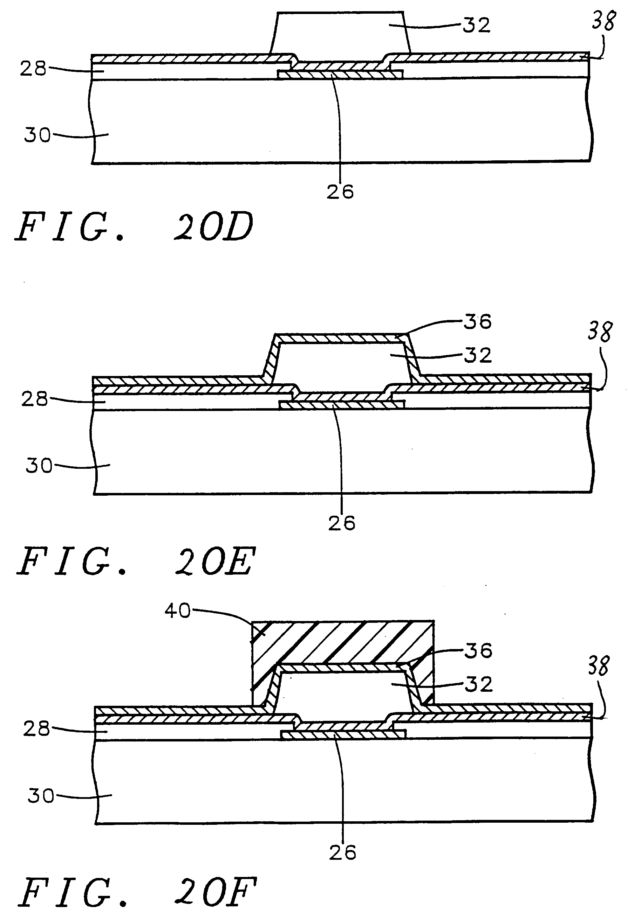

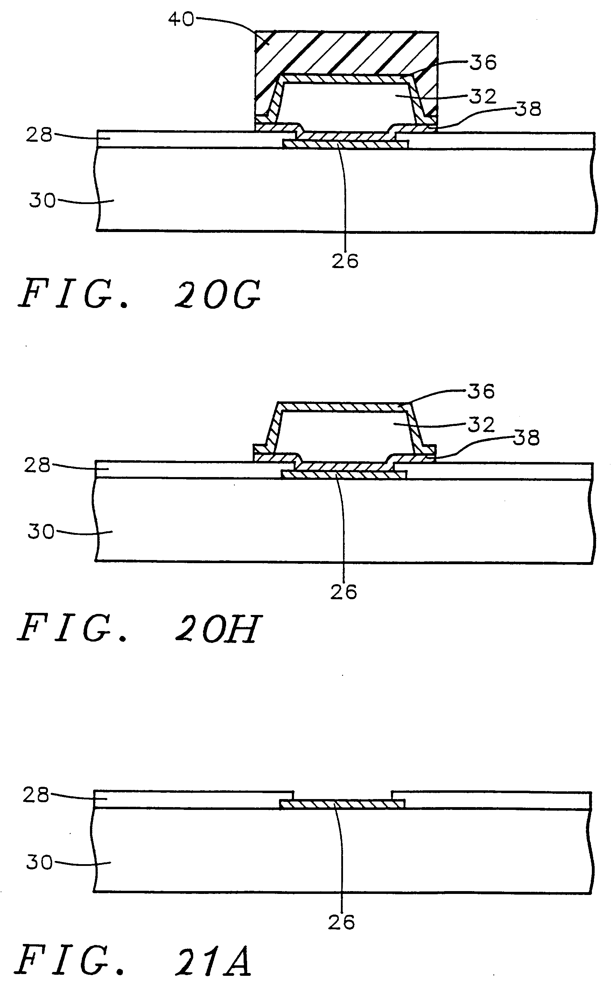

Another embodiment method is shown in Figs. 20A through 20J. The integrated circuit element or substrate 30 with a passivation layer 28 and aluminum input/output pads 26 with a diameter of about 90 microns is etched and cleaned, as shown in Fig. 20A. Next, as shown in Fig. 20B, a layer of metal 38 such as aluminum is deposited on the integrated circuit element or substrate 30. The method then proceeds as described in the immediately preceding embodiment beginning with the formation of the layer of photosensitive polyamic acid polyimide 32 and continuing until the conductive metal coating 36 is etched, Figs. 20C to 10G. The aluminum 38 is then etched using H₃PO₄:CH₃COOH:HNO₃:H₂O (4:4:1:1) at room temperature at about 350 Angstroms/minute. As shown in Fig. 20H the photoresist is then stripped and the composite bump is formed.

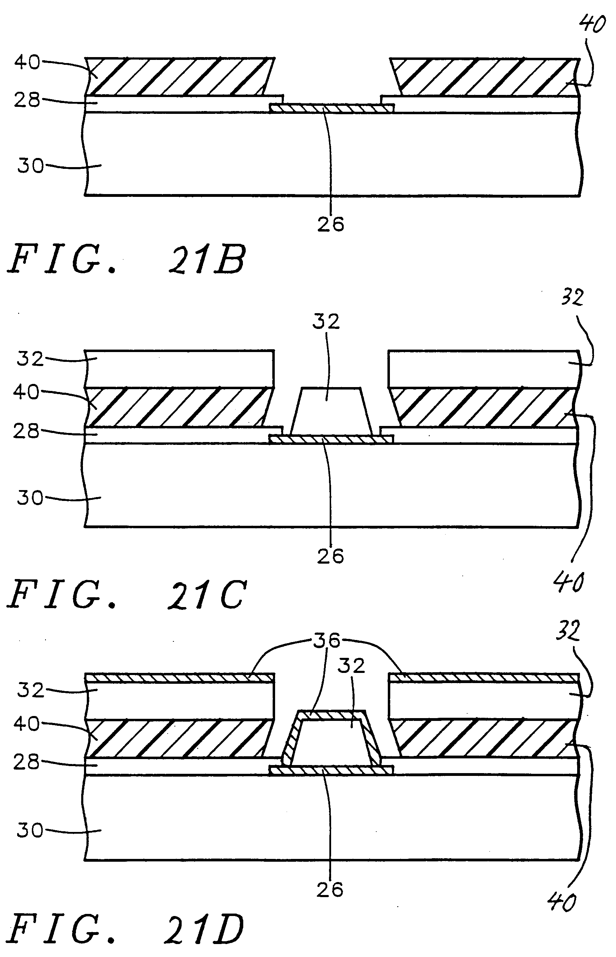

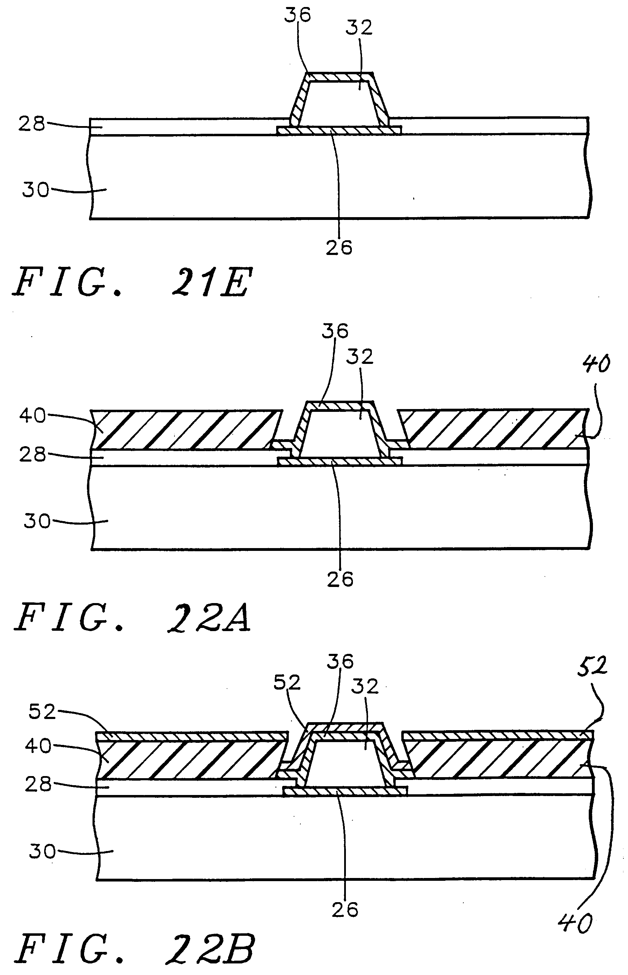

Another embodiment is shown in Figs. 21A through 21E. First the integrated circuit element or substrate 30 with about 90 micron diameter input/output pads 26 is etched and cleaned, Fig. 21A. Next a photo resist mask 40 is formed leaving photoresist everywhere except over the input/output pads 26, Fig. 21B. Next a layer of polymer 32 is formed on the integrated circuit element of substrate 30 using vapor deposition polymerization. In a vacuum of about 3.75 X 10⁻⁵ Torr 4,4 Oxy-Dianiline (ODA) is sprayed onto the integrated circuit element or wafer and heated to between about 80°C and 160°C. While still at 3.75 X 10⁻⁵ Torr pyromellitic dianhydride (PMDA) is sprayed onto the integrated circuit element or wafer and heated to between about 130°C and 180°C. Vapor deposition polymerization is described by Takahashi et al in MACROMOLECULES, Vol. 24, No. 12, 1991, pp. 3543-3546. Next, as shown in Fig. 21D, a conductive metal layer 36 such as a composite of chrome/gold with chrome about 500 Angstroms thick and gold about 2000 Angstroms thick is deposited on the integrated circuit element or substrate 30. The coating 36 can also be the same metals described in the previous embodiments. Then the photoresist mask 40 is removed thereby removing the polymer and metal deposited on the photoresist leaving the composite bump, Fig. 21E.

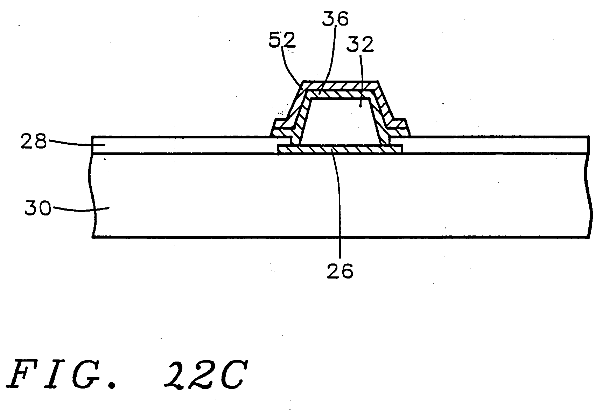

Another embodiment when a solder coating is desired on the composite bump is shown in Figs. 22A through 22C. Composite bumps are formed on the integrated circuit element or substrate 30 using any of the preceding embodiment methods. In this case the preferred conductive metal coatings are chrome/copper/gold, chrome/nickel/gold, chrome/silver/gold, titanium/platinum/gold, or titanium/palladium/gold. A layer of photoresist 40 is then formed on the surface of the integrated circuit element or substrate 30 and patterned so that only the composite bumps are exposed, Fig. 22A. Solder 52, preferably 95% lead 5% tin is then deposited using chemical vapor deposition, Fig. 22B. Other percentages of lead and tin or solders using indium-tin or indium-gallium can also be used. The photoresist is then stripped thereby also removing the solder everywhere except on the composite bumps, Fig. 22C.

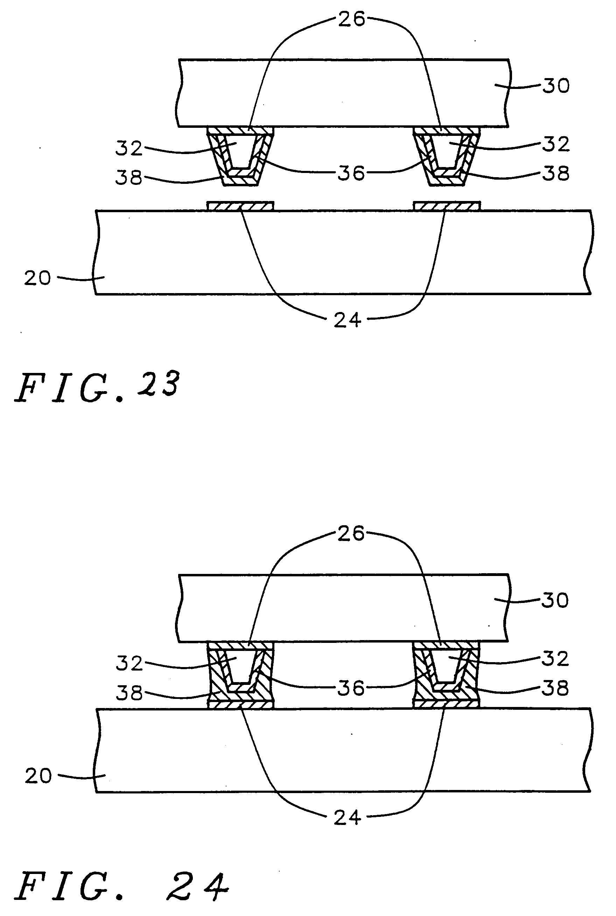

Refer now more particularly to Figs. 23 and 24, there is shown an embodiment for the bonded structure of the current invention. As shown in Fig. 23 composite bumps are formed on the integrated circuit element input/output pads 26 which are a metal such as aluminum about 90 microns in diameter. Each composite bump is composed of a polymer body 32 such as polyamic acid polyimide with a thickness between about 5 and 25 microns, a conductive metal coating 36 covering the polymer body, and a soldering metal coating 38 covering the conductive metal coating. The conductive metal coating must adhere to the polymer body and can be a composite such as chrome/copper/gold, chrome/nickel/gold, chrome/silver/gold, titanium/tungsten/gold, titanium/platinum /gold, or titanium/palladium/gold. For chrome/copper/gold the thickness can be about 500 Angstroms chrome/500 Angstroms copper/2000 Angstroms gold. The soldering metal layer can be metal alloys such as lead-tin, indium-gallium, or indium-tin. For lead-tin the soldering metal layer can be 95% lead-5% tin with a thickness of between about 1 and 20 microns. Substrate input/output pads 24 are formed on the substrate 20 and are formed from a metal the solder will wet such as chrome/copper/gold or other metal composites used for the conductive metal coating on the polymer body of the composite bump. Fig. 24 shows the bonded structure after soldering. The soldering metal 38 bonds the composite bump structure to the substrate input/output pads 24.

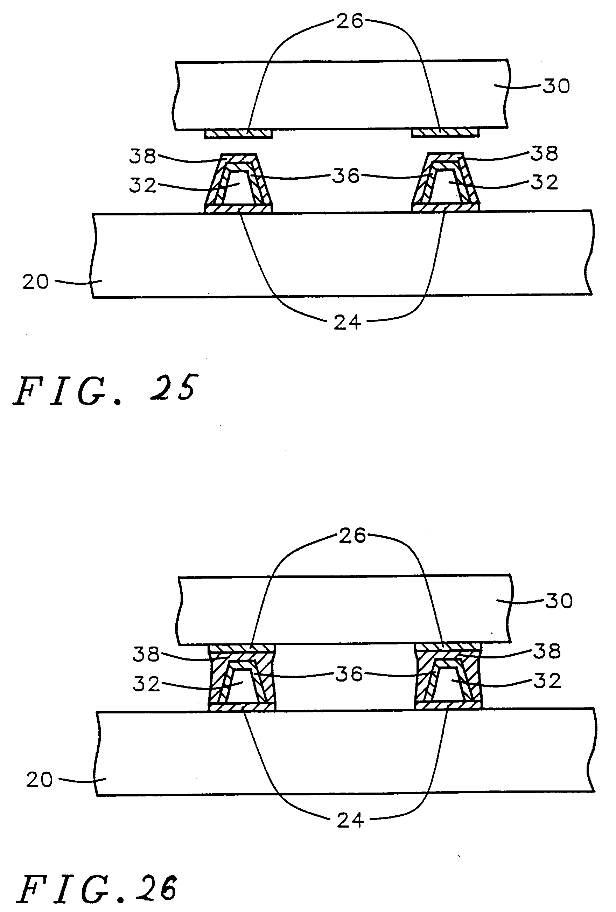

Figs. 25 and 26 shows another embodiment of the bonded structure. As shown in Fig. 25 the composite bumps are formed on the substrate 20 input/output pads 24 which are a metal such as aluminum about 90 microns in diameter. Each composite bump is composed of a polymer body 32 such as polyamic acid polyimide with a thickness between about 5 and 25 microns, a conductive metal coating 36 covering the polymer body, and a soldering metal coating 38 covering the conductive metal coating. The conductive metal coating must adhere to the polymer body and can be a composite such as chrome/copper/gold, chrome/nickel/gold, chrome/silver/gold, titanium/tungsten/gold, titanium/platinum/gold, or titanium /palladium/gold. For chrome/copper/gold the thickness can be about 500 Angstroms chrome/500 Angstroms copper/2000 Angstroms gold. The soldering metal layer can be metal alloys such as lead-tin, indium-gallium, or indium-tin. For lead-tin the soldering metal layer can be 95% lead-5% tin with a thickness of between about 1 and 20 microns. Integrated circuit element input/output pads 26 are formed on the integrated circuit element 30 and are formed a metal the solder will wet such as chrome/copper gold or other metal composites used for the conductive metal coating on the polymer body of the composite bump. Fig. 26 shows the bonded structure after soldering. The soldering metal 38 bonds the composite bump structure to the integrated circuit element input/output pads 26.

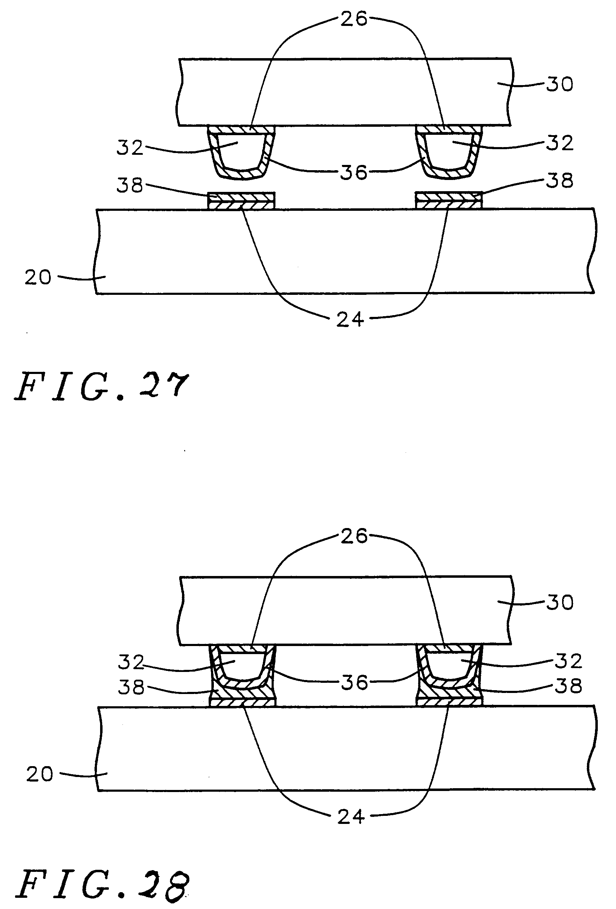

Figs. 27 and 28 shows another embodiment of the bonded structure. As shown in Fig. 27 the composite bumps are formed on the integrated circuit element input/output pads 26 which are a metal such as aluminum about 90 microns in diameter. Each composite bump is composed of a polymer body 32 such as polyamic acid polyimide with a thickness between about 5 and 25 microns and a conductive metal coating 36 covering the polymer body. The conductive metal coating must adhere to the polymer body and can be a composite such as chrome/copper/gold, chrome/nickel/gold, chrome/silver/gold, titanium/tungsten/gold, titanium/platinum/gold, or titanium /palladium/gold. For chrome/copper/gold the thickness can be about 500 Angstroms chrome/500 Angstroms copper/2000 Angstroms gold. The soldering metal 38 is formed on the substrate 20 input/output pads 24 which must be a metal wettable by the solder, for example copper, chrome/copper/gold. The soldering metal can be 95% lead-5% tin, other alloys of lead-tin, alloys of indium-gallium, or alloys of indium-tin. Fig. 28 shows the bonded structure after soldering. The soldering metal 38 bonds the composite bump structure to the substrate input/output pads 24.

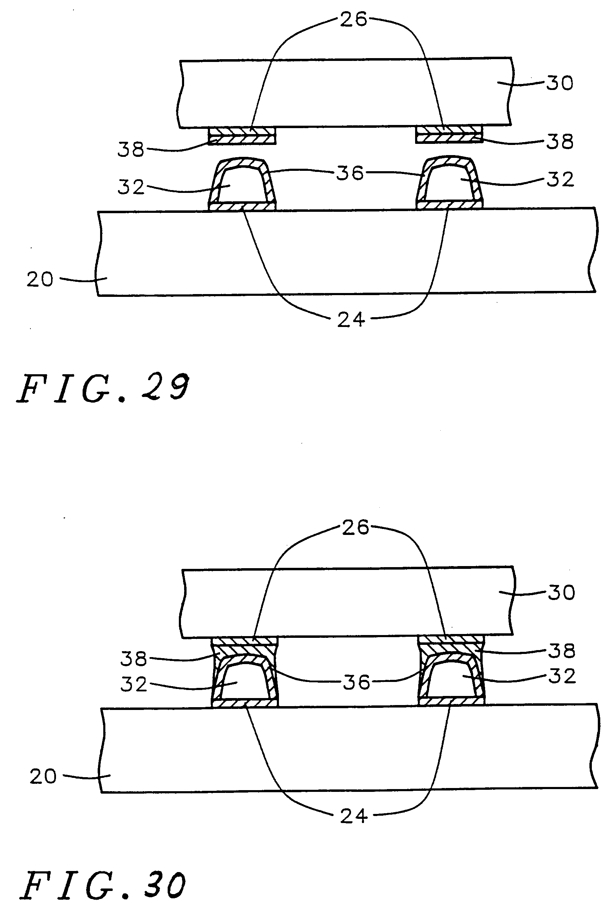

Figs. 29 and 30 shows another embodiment of the bonded structure. As shown in Fig. 29 the composite bumps are formed on the substrate 20 input/output pads 24 which are metal such as aluminum and about 90 microns in diameter. Each composite bump is composed of a polymer body 32 such as polyamic acid polyimide with a thickness between about 5 and 25 microns and a conductive metal coating 36 covering the polymer body. The conductive metal coating must adhere to the polymer body and can be a composite such as chrome/copper/gold, chrome/nickel/gold, chrome/silver/gold, titanium/tungsten/gold, titanium /platinum/gold, or titanium/palladium/gold. For chrome/copper/gold the thickness can be about 500 Angstroms chrome/500 Angstroms copper/2000 Angstroms gold. The soldering metal 38 is formed on the integrated circuit element 30 input/output pads 26 which must be a metal wettable by the solder, for example chrome/copper/gold or other composites used as the conductive metal coating covering the polymer body. The soldering metal can be 95% lead-5% tin, other alloys of lead-tin, alloys of indium-gallium, or alloys of indium-tin. Fig. 30 shows the bonded structure after soldering. The soldering metal 38 bonds the composite bump structure to the integrated circuit element input/output pads 26.

Figs. 23 and 24 shows an embodiment of a method of forming the bonded structure of the current invention. As shown in Fig. 23 composite bumps are formed on the integrated circuit element input/output pads 26 which are a metal such as aluminum. Each composite bump is composed of a polymer body 32 such as polyamic acid polyimide, a conductive metal coating 36 covering the polymer body, and a soldering metal coating 38 covering the conductive metal coating. The conductive metal coating must adhere to the polymer body and can be a composite such as chrome/copper/gold, chrome/nickel/gold, chrome/silver /gold, titanium/tungsten/gold, titanium/platinum/gold, or titanium/palladium/gold. For chrome/copper gold the thickness can be about 500 Angstroms chrome/500 Angstroms copper/2000 Angstroms gold. The soldering metal layer 38 can be metal alloys such as lead-tin, indium-gallium, or indium-tin. For lead-tin the soldering metal layer can be 95% lead-5% tin with a thickness of between about 1 and 20 microns. Substrate input/output pads 24 are formed on the substrate 20 and are formed from a metal the solder will wet such chrome/copper/gold or other metal composites used for the conductive metal coating on the polymer body of the composite bump.

The integrated circuit element 30 and the substrate 20 are then brought together so that the composite bumps are brought together with the substrate input/output pads 24. Heat is applied to the soldering metal 38 thereby raising its temperature to about 30°C above the melting point of the soldering metal used. For the 95% lead-5% tin solder alloy the temperature is raised to about 350°C. The soldering metal melts wetting the substrate input/output pads 24, the heat is removed, and as the solder cools below the melting point the bonded structure is formed. Due to the low Young's Modulus of the polymer body the stress tending to break the solder joint during or after the soldering process is extremely small.

Figs. 25 and 26 shows another embodiment of a method of forming the bonded structure. As shown in Fig. 25 the composite bump is formed on the substrate 20 input/output pad 24 prior to bonding. The composite bump includes a polymer body 32, a conductive metal coating 36, and a soldering metal coating 38 such as alloys of lead-tin, indium-gallium, or indium-tin. The integrated circuit element 30 input/output pad 26 is formed from a metal wettable by the solder used.

The integrated circuit element 30 and the substrate 20 are then brought together so that the composite bumps are brought together with the integrated circuit element 30 input/output pads 24. Heat is applied to the soldering metal 38 thereby raising its temperature to about 30°C above the melting point of the soldering metal used. For the 95% lead-5% tin solder alloy the temperature is raised to about 350°C. The soldering metal melts wetting the integrated circuit element input/output pads 26, the heat is removed, and as the solder cools below the melting point the bonded structure is formed. Due to the low Young's Modulus of the polymer body the stress tending to break the solder joints during or after the soldering process is extremely small.

Figs. 27 and 28 shows another embodiment of a method of forming the bonded structure. As shown in Fig. 27 the composite bump is formed on the integrated circuit element 30 input/output pads 26 prior to bonding. The composite bump includes a polymer body 32 and a conductive metal coating 36. A soldering metal coating 38, such as alloys of lead-tin, indium-gallium, or indium-tin, is formed on the substrate 20 input/output pads 24. The substrate 20 input/output pads 24 are formed from a metal wettable by the solder used. The integrated circuit element 30 and the substrate 20 are then brought together so that the composite bumps are brought together with the substrate 20 input/output pads 24. The soldering process then proceeds as described in the previous embodiments.

Figs. 29 and 30 shows another embodiment of a method of forming the bonded structure. As shown in Fig. 29 the composite bump is formed on the substrate 20 input/output pads 24 prior to bonding. The composite bump includes a polymer body 32 and a conductive metal coating 36. A soldering metal coating 38, such as alloys of lead-tin, indium-gallium, or indium-tin, is formed on the integrated circuit element 30 input/output pads 26. The integrated circuit element 30 input/output pads 26 are formed from a metal wettable by the solder used. The integrated circuit element 30 and the substrate 20 are then brought together so that the composite bumps are brought together with the integrated circuit element 30 input/output pads 26. The soldering process then proceeds as described in the previous embodiments.

While the invention has been particularly shown and decribed with reference to the preferred embodiments thereof, it will be understood by those skilled in the art that various changes in form and details may be made without departing from the spirit and scope of the invention.

## Claims

1. A bonded structure, which comprises the physical and electrical connection between the integrated circuit element (30) and the next level of integration, comprising:
an integrated circuit element (30) having input/output pads (26);
a substrate (20) having input/output pads (24); and
a plurality of physical and electrical connections
between said integrated circuit element (30) input/output pads (26) and said substrate input/output pads (24) wherein each said connection includes a composite bump comprised of a polymer body (32) and a conductive metal coating (36) covering said polymer body (32), and wherein said composite bump is deformed when said connection is formed.

2. A bonded structure, especially a composite bump structure, which comprises:
an integration circuit element (30) or substrate with input/output pads (26); and
composite bumps formed from a polymer body (32) covered by a conductive metal coating (36) formed on said input/output pads (26).

3. A bonded structure, which comprises the physical and electrical connection between the integrated circuit element (30) and the next level of integration, comprising:
an integrated circuit element (30) having input/output pads (26);
a substrate (20) having input/output pads (24); and
a plurality of physical and electrical connections
between said integrated circuit element (30) input/output pads (26) and said substrate input/output pads (24) wherein each said connection includes a soldering metal (8) and a composite bump comprised of a single polymer body (32) with a conductive metal coating (36) covering said polymer body (32) wherein said connections are formed by soldering.

4. The bonded structure of claims 1 to 3 wherein said polymer of said polymer body (32) is polyamic acid polyimide.

5. The bonded structure of claim 1 wherein said conductive metal coating (36) is comprised of an adhesion layer, a barrier layer and a conductor layer.

6. The bonded structure of claim 1 wherein said composite bumps are formed on said integrated circuit element input/output pads (24) prior to formation of said connection.

7. The bonded structure of claim 1 wherein said composite bumps are formed on said substrate input/output pads (24) prior to formation of said connection.

8. The bonded structure of claim 1 wherein said composite bumps are formed on both said integrated circuit element (30) input/output pads (26) and substrate (20) input/output pads (24) prior to formation of said connection.

9. The bonded structure of claim 2 wherein a base metal is formed under said composite bumps and on top of said input/output pads (26).

10. The bonded structure of claim 9 wherein said base metal is aluminum.

11. The bonded structure of claim 2 wherein said conductive metal coating (36) is a layer of chrome about 500 Angstroms thick and a layer of gold about 2000 Angstroms thick.

12. The bonded structure of claim 2 wherein said conductive metal coating (36) includes an adhesion layer, a barrier layer, and a conductor layer.

13. The bonded structure of claim 2 wherein said conductive metal coating (36) is coated with solder.

14. The bonded structure of claim 13 wherein said solder is 95% lead and 5% tin.

15. The bonded structure of claim 2 wherein said composite bumps extend beyond the edges of said input/output pads (26).

16. The bonded structure of claim 2 wherein said composite bumps are in a ring around said input/output pads (26).

17. The bonded structure of claim 3 wherein said conductive metal coating (36) is a composite of 500 Angstroms chrome/500 Angstroms copper/2000 Angstroms gold.

18. The bonded structure of claim 3 wherein said soldering metal is 95% lead-5% tin.

19. The bonded structure of claim 3 wherein said composite bumps are formed on said integrated circuit element (30) input/output pads (26) prior to soldering.

20. The bonded structure of claim 19 wherein said soldering metal is formed on said composite bumps prior to soldering.

21. The bonded structure of claim 19 wherein said soldering metal is formed on said substrate input/output pads (24) prior to soldering.

22. The bonded structure of claim 3 wherein said composite bumps are formed on said substrate input/output pads (24) prior to soldering.

23. The bonded structure of claim 22 wherein said soldering metal is formed on said composite bumps prior to soldering.

24. The bonded structure of claim 22 wherein said soldering metal is formed on said integrated circuit element (30) input/output pads (26) prior to soldering.

25. A method of forming a bonded structure by joining of integrated circuit elements to the next level of integration, or that level of integration to the following level according to claims 1, 4 to 6, comprising the steps of:
providing an integration circuit element with input/output pads;
providing a substrate with input/output pads;
providing composite bumps comprised of a polymer body and a conductive metal coating covering said polymer body formed on said integrated circuit input/output pads;
bringing together said integrated circuit element and said substrate so that said composite bumps contact said substrate input/output pads and are deformed during said contact; and
bonding said composite bumps to said substrate input/output pads.

26. A method of forming a bonded structure by joining of integrated circuit elements to the next level of integration, or that level of integration to the following level according to claims 1, 4 and 5 and 7, comprising the steps of:
providing an integrated circuit element with input/output pads;
providing a substrate with input/output pads;
providing composite bumps comprised of a polymer body and a conductive metal coating covering said polymer body formed on said substrate input/output pads;
bringing together said integrated circuit element and said substrate so that said composite bumps contact said integrated circuit element input/output pads and are deformed during said contact; and
bonding said composite bumps to said integrated circuit element input/output pads.

27. A method of forming a bonded structure by joining of integrated circuit elements to the next level of integration, or that level of integration to the following level according to claims 1, 4 and 5 and 8, comprising the steps of:
providing an integrated circuit element with input/output pads;
providing a substrate with input/output pads;
providing composite bumps comprised of a polymer body and a conductive metal coating covering said polymer body formed on said integrated circuit input/output pads and on said substrate input/output pads;
bringing together said integrated circuit element and said substrate so that said integrated circuit element composite bumps contact said substrate composite bumps and said integrated circuit element composite bumps and said substrate composite bumps are deformed during said contact; and
bonding said integrated circuit element composite bumps to said substrate composite bumps.

28. A method of forming a bonded structure by joining of integrated circuit elements to the next level of integration or that level of integration to the following level according to claims 9 to 16, for forming composite bumps comprising the steps of:
providing an integrated circuit element or substrate with input/output pads;
forming a polymer layer on the surface of said integrated circuit element or substrate;
forming a first photoresist mask on said polymer layer directly over said input/output pads;
etching said polymer not protected by first photoresist mask;
stripping said first photoresist mask;
forming a conductive metal layer over the surface of said integrated circuit element or substrate;
forming a second photoresist mask on said conductive metal layer directly over said input/output pads;
etching said conductive metal not protected by said second photoresist mask; and
stripping said second photoresist mask.

29. A method of forming a bonded structure by joining of integrated circuit elements to the next level of integration or that level of integration to the following level according to claims 9 to 16, for forming composite bumps comprising the steps of:
providing an integrated circuit element or a subtrate with input/output pads;
forming a layer of photosensitive polymer on the surface of said integrated circuit element or substrate;
exposing and developing a pattern on said photosensitive polymer so as to leave photosensitive polymer directly over said input/output pads only;
forming a conductive metal layer over the surface of said integrated circuit element or substrate;
forming a first photoresist mask on said conductive metal layer directly over said input/output pads;
etching said conductive metal layer not protected by said first photoresist mask; and stripping said first photoresist mask.

30. A method of forming a bonded structure by joining of integrated circuit elements to the next level of integration or that level of integration to the following level according to claims 9 to 16, for forming composite bumps comprising the steps of:
providing an integrated circuit element or substrate with input/output pads;
forming a first photoresist mask by lithography over said integrated circuit element or substrate surface except those areas directly over said input/output pads;
forming a layer of non photosensitive polymer over the surface of said integrated circuit element or substrate using vapor deposition polymerization;
forming a conductive metal layer over said integrated circuit element or substrate; and
removing said first photoresist mask thereby removing said non photosensitive polymer and said conductive metal over said photoresist mask, leaving said non photosensitive polymer and said conductive metal over said input/output pads.

31. A method of forming a bonded structure by joining of integrated circuit elements to the next level of integration, or that level of integration to the following level according to claims 1, 4 to 8, comprising the steps of:
providing an integrated circuit element with input/output pads and composite bumps comprised of a single polymer body and a conductive metal coating covering said polymer body formed on said integrated circuit element input/output pads;
providing a substrate with input/output pads;
providing a soldering metal;
bringing together said composite bumps formed on said integrated circuit element input/output pads, said substrate input/output pads, and said soldering metal;
heating said soldering metal to a temperature of about 30°C above the melting point of said soldering metal; and cooling said soldering metal below the melting point of said soldering metal.

32. A method of forming a bonded structure by joining of integrated circuit elements to the next level of integration, or that level of integration to the following level according to claims 1, 4 to 8, comprising the steps of:
providing a substrate with input/output pads and composite bumps comprised of a single polymer body and a conductive metal coating covering said polymer body formed on said substrate input/output pads;
providing an integrated circuit element with input/output pads;
providing a soldering metal;
bringing together said composite bumps formed on said substrate input/output pads, said integrated circuit element input/output pads, and said soldering metal;
heating said soldering metal to a temperature about 30°C above the melting point of said soldering metal; and
cooling said soldering metal below the melting point of said soldering metal.

33. The method of claims 28 and 30 wherein said polymer is polyamic acid polyimide.

34. The method of claim 29 wherein said polymer is photosensitive polyamic acid polyimide.

35. The method of claims 25, 26, 27, 28, 29 or 30 wherein said conductive metal coating is comprised of an adhesion layer, a barrier layer and a conducter layer.

36. The method of claim 25 wherein said bonding is provided by a conductive adhesive between said composite bumps and said substrate input/output pads.

37. The method of claim 26 wherein said bonding is provided by a conductive adhesive between said composite bumps and said integrated circuit input/output pads.

38. The method of claim 27, wherein said bonding is provided by a conductive adhesive applied between two said composite bumps.

39. The method of claim 25, 26 or 27 wherein said bonding is provided by a nonconductive adhesive between said integrated circuit element and said substrate.

40. The method of claim 25, 26 or 27 wherein said bonding is provided by thermocompression bonding.

41. The method of claim 25, 26 or 27 wherein said bonding is provided by application of heat energy.

42. The method of claim 25, 26 or 27 wherein said bonding is provided by application of light energy.

43. The method of claim 25, 26 or 27 wherein said bonding is provided by ultrasonic bonding.

44. The method of claim 25, 26 or 27 wherein said bonding is provided by tape automated bonding.

45. The method of claims 28 or 29, further comprising:
forming a base metal layer on the integrated circuit element or substrate prior to forming said polymer layer; and
etching said base metal not protected by said second photoresist mask, after etching said conductive metal, and before stripping said second photoresist mask.

46. The method of claim 45 wherein said base metal is aluminum.

47. The method of claims 28, 29 or 30 wherein said conductive metal coating is a layer of chrome about 500 Angstroms thick and a layer of gold about 2000 Angstroms thick.

48. The method of claims 28, further comprising:
forming a third photoresist mask on said integrated circuit element or substrate, after the second photoresist mask has been stripped, covering the entire integrated circuit element or substrate surface except the area directly over the input/output pads;
forming a layer of soldering metal on said third photoresist mask and said composite bumps; and
stripping said third photoresist mask thereby leaving soldering metal only on the composite bumps.

49. The method of claim 29, further comprising:
forming a second photoresist mask on said integrated circuit element or substrate, after the first photoresist mask has been stripped, covering the entire integrated circuit element or substrate surface except the area directly over the input/output pads;
forming a layer of soldering metal on said second photoresist mask and said composite bumps; and
stripping said second photoresist mask thereby leaving only the soldering metal on the composite bumps.

50. The method of claim 30, further comprising:
forming a second photoresist mask on said integrated circuit element or substrate by lithography, after the first photoresist mask has been stripped, covering the entire integrated circuit element or substrate surface except the area directly over the input/output pads;
forming a layer of soldering metal on said second photoresist mask and said composite bumps; and
stripping said second photoresist mask thereby leaving only the soldering metal on the composite bumps.

51. The method of claim 30 wherein said vapor deposition polymerization comprises:
providing a vacuum of about 3.75 X 10⁻⁵ Torr;
spraying 4,4 Oxy-Dianiline onto said integrated circuit element or substrate;
heating said integrated circuit element or substrate to between about 80°C and 160°C;
spraying pyromellitic dianhydride onto said integrated circuit element or substrate; and
heating said integrated circuit element or substrate to between about 130°C and 180°C.

52. The method of claims 31 or 32 wherein said conductive metal coating is a composite of 500 Angstroms chrome/500 Angstroms copper/2000 Angstroms gold.

53. The method of claims 31 or 32 wherein said soldering metal is formed on said composite bumps prior to heating said soldering metal.

54. The method of claims 31 or 32 wherein said soldering metal is formed on said substrate input/output pads prior to heating said soldering metal.

55. The method of claim 32 wherein said soldering metal is applied on the IC substrate input/output pads prior to heating said soldering metal.

56. The method of claims 31, 32, 47, 48 or 49 wherein said soldering metal is 95% lead and 5% tin.
